# EUROPEAN PATENT APPLICATION

(11) **EP 1 515 181 A1**
(43) Date of publication of application: **16.03.2005**
(21) Application number: 03733428.1
(22) Date of filing: 13.06.2003
(51) Int. Cl.: G02F 1/133, H05B 33/14, H05B 33/26, G09F 9/40, G09F 9/30, G09G 3/36, G09G 3/20

(54) **DISPLAY**

(30) Priority: 20.06.2002 JP 2002179931
(71) Applicant: SHARP KABUSHIKI KAISHA, Osaka 545-8522 (JP)
(72) Inventor: IKEDA, Hiroshi, Nasu-gun, Tochigi 329-2711 (JP)
(74) Representative: Müller, Frithjof E., Dipl.-Ing.
(86) International application number: PCT/JP2003/007549
(87) International publication number: WO 2004/001491

(57) **Abstract**

A display apparatus comprises transparent display elements arranged on a transparent substrate, a display panel DP whose display image can be observed from either side, a pair of liquid crystal shutter means 2as and 2bs disposed in such a manner as to sandwich the display panel DP, display control means 13 and 15 for displaying, on the display panel, a mirror image of an image to be displayed in every other frame, and liquid crystal shutter control means 14 for opening and closing the pair of liquid crystal shutter means in synchronism with the operation of the display control means such that they do not open simultaneously in each frame scan. The pair of liquid crystal shutter means are opened and closed such that the mirror image can be observed as a regular image on one side of the display panel DP. Image information displayed on the display panel can be viewed simultaneously from both the front surface and the back surface of the display panel.

## Description

### TECHNICAL FIELD

The present invention relates to a display technology for viewing a display panel from both a front surface and a back surface thereof simultaneously.

### BACKGROUND ART

In a display apparatus for displaying textual information, image information, and the like, there are cases where one person who faces the display surface of the display apparatus and another person who faces the back of the display surface wish to view the information displayed on the display apparatus almost simultaneously in a face-to-face manner. Circumstances where it is desirable to share the information displayed on the display apparatus include a case where the simulation results of insurance premiums, for example, must be explained when soliciting for an insurance contract from a customer, and a case where a product description or presentation is made using the display apparatus, for example.

As a display apparatus for such purposes, JP Patent Publication (Kokai) No. 61-185853 A (1986) discloses an apparatus using a flat Braun tube. Also, JP Patent Publication (Kokai) No. 9-190158 A (1997) discloses a technology by which a shutter is disposed on each display surface of a pair of image display apparatuses positioned back to back, and switching is performed by the shutter depending on whether or not to use the image display apparatuses.

### DISCLOSURE OF THE INVENTION

However, in the apparatus using a flat Braun tube in the aforementioned prior art, a structure is necessary for supporting the weight of the Braun tube per se, so that the size of the display apparatus per se increases. There is another problem that power consumption increases since the display unit employs a Braun tube, as compared with a display panel using liquid crystal, for example. For these reasons, the display apparatus using a flat Braun tube is not suitable especially for mobile/portable purposes.

Moreover, in the technology using a pair of liquid crystal display apparatuses disclosed in JP Patent Publication (Kokai) No. 9-190158 A (1997), two liquid crystal display apparatuses adapted for color display are necessary especially when color display is required, resulting in an increase in production cost.

The present invention is proposed so as to solve the problems as mentioned above. It is an object of the present invention to provide a display apparatus such that images displayed on a display panel can be viewed from both a front surface and a back surface of the display panel in the same manner.

In order to achieve the aforementioned object, the invention according to claim 1 provides a display apparatus comprising: a display panel whose display can be observed from either side; a pair of liquid crystal shutter means disposed in such a manner as to sandwich the display panel; display control means for displaying a mirror image of display on the display panel in every other frame or every other field; and liquid crystal shutter control means for opening and closing the pair of liquid crystal shutter means in synchronism with the operation of the display control means in each frame scan or each field scan such that they do not open simultaneously, wherein the pair of liquid crystal shutter means are opened and closed by the liquid crystal shutter control means such that the mirror image can be observed as the original display on one side of the display panel.

In accordance with claim 2 of the invention, the display control means comprises a scan inverting circuit for inverting the direction of a horizontal scan on the display panel in each frame or each field, and the liquid crystal shutter control means controls the switching of the opening and closing of the pair of liquid crystal shutter means in response to an output from the scan inverting circuit.

In order to achieve the aforementioned object, the invention according to claim 3 provides a display apparatus comprising: a display panel comprising a plurality of picture elements of which each is composed of a pair of display elements, wherein display can be observed from either side of the display panel; a pair of liquid crystal shutter means disposed in such a manner as to sandwich the display panel; display control means for driving each of the display elements such that a mirror image of display that is being made by a set of display elements consisting of one of each pair of display elements can be displayed by another set of display elements consisting of the other of each pair of display elements; and liquid crystal shutter control means for opening and closing the pair of liquid crystal shutter means in synchronism with the operation of the display control means in each frame scan or each field scan such that they do not open simultaneously, wherein the pair of liquid crystal shutter means are opened and closed by the liquid crystal shutter control means such that the mirror image can be observed as the original display on one side of the display panel.

In accordance with claim 4 of the invention, the display control means causes the mirror image to be displayed alternately in each horizontal scan by the one set and the other set of each pair of display elements.

The invention further provides a display apparatus comprising: a display panel having a plurality of picture elements that perform display based on an input signal, the display panel being capable of display on both surfaces, namely a first surface and a second surface, thereof, using a picture element at a selected location; first shutter means and second shutter means disposed on the first surface side and the second surface side, respectively, the first and second shutter means being capable of opening and closing for a single picture element or a plurality of picture elements; and control means comprising display control means for performing display control such that a first display observed from the first surface side and a second display observed from the second surface side can be viewed as the same display, and shutter control means for controlling the opening and closing of the shutters such that the display picture elements on the second surface side are screened by the second shutter means upon the first display and the display picture elements on the first surface side are screened by the first shutter means upon the second display.

The invention further provides a display apparatus comprising: a display panel having a plurality of picture elements, each including at least two, namely a first and a second, display elements disposed closely to each other, which is capable of display from both surfaces, namely a first display surface and a second display surface, thereof, using a picture element at a selected location; first shutter means and second shutter means disposed on the first display surface side and the second display surface side, respectively, that are capable of opening and closing for each of the display elements; and control means comprising display control means for performing display control such that a first display observed from the first display surface side and a second display observed from the second display surface side can be viewed as the same display, and shutter control means for controlling the opening and closing of the shutters such that the display picture elements on the second display surface side are screened by the second shutter means upon the first display and the display picture elements on the first display surface side are screened by the first shutter means upon the second display.

The invention further provides a display apparatus comprising: a display panel having a plurality of picture elements that perform display based on an input signal, the display panel being capable of display on both surfaces, namely a first surface and a second surface, thereof, using a picture element at a selected location; first shutter means and second shutter means disposed on the first surface side and the second surface side, respectively, that are capable of opening and closing for a single picture element or a plurality of picture elements; and control means comprising display control means for performing display control of a first display observed from the first surface side and a second display, which is different from the first display, observed from the second surface side, and shutter control means for controlling the opening and closing of the shutters such that the display picture elements on the second surface side are screened by the second shutter means upon the first display and the display picture elements on the first surface side are screened by the first shutter means upon the second display.

The invention further provides a display apparatus comprising: a display panel having a plurality of picture elements, each including at least two, namely a first and a second, display elements disposed closely to each other, that can provide a display on both surfaces, namely a first display surface and a second display surface, thereof, using a picture element at a selected location; first shutter means and second shutter means disposed on the first surface side and the second surface side, respectively, that are capable of opening and closing for each the display element; and control means comprising display control means for performing display control of a first display observed from the first display surface side and a second display, which is different from the first display, observed from the second display surface side, and shutter control means for controlling the opening and closing of the shutters such that the display picture elements on the second display surface side are screened by the second shutter means upon the first display and the display picture elements on the first display surface side are screened by the first shutter means upon the second display.

### BRIEF DESCRIPTION OF THE DRAWINGS

Fig. 1 shows a cross-sectional view of an example of a display element used in a display apparatus according to a first embodiment of the present invention.
Fig. 2 shows a block diagram of a configuration of a control circuit for driving a display apparatus using the display element of Fig. 1.
Fig. 3(a), (b), (c), and (d) show a timing chart for describing the operation of the control circuit shown in Fig. 2.
Fig. 4 shows a display apparatus according to a second embodiment of the present invention, in which a single picture element comprises two display elements and each display element is sandwiched by a pair of liquid crystal shutters.
Fig. 5 shows a circuit diagram of an example of the display panel of a display apparatus according to the second embodiment of the present invention.
Fig. 6 shows a block diagram of a configuration of a control circuit for driving a display apparatus using the display panel of Fig. 5.
Fig. 7(a) and (b) show a timing chart for describing the operation of the control circuit shown in Fig. 6.

### BEST MODE FOR CARRYING-OUT OF THE INVENTION

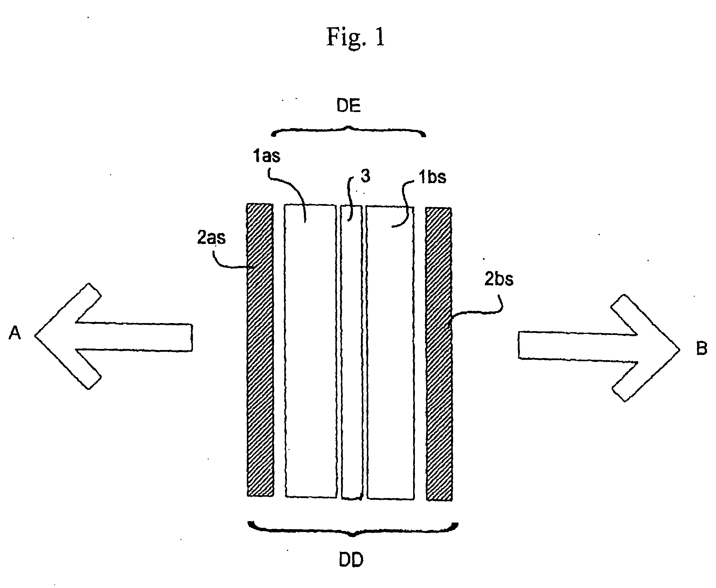

Fig. 1 shows a cross-sectional view of the structure of a display unit DD, which is a display panel that can be used for a display apparatus according to the embodiments of the present invention. The display unit DD comprises a display element DE comprising a light transmission type organic electroluminescence element (to be hereafter referred to as "light transmission type organic EL element"), and a pair of switches that sandwich the display element DE. As shown in Fig. 1, the display unit DD comprises the display element DE and a pair of liquid crystal shutters 2as and 2bs that sandwich the display element DD. The display element DE has a structure such that a light transmission type organic EL element 3 is formed on one substrate 1as of a pair of transparent substrates 1as and 1bs, and the light transmission type organic EL element 3 is sandwiched by the other transparent substrate 1bs. The pair of liquid crystal shutters 2as and 2bs are attached to the outer surfaces of the transparent substrates 1as and 1bs respectively such that they are integrated to constitute the display unit DD as a single picture element.

The light transmission type organic EL element 3, which is well-known, can be formed by disposing a transparent anode layer, a hole transport layer, a light emitting layer, an organic electron injecting layer, and a transparent cathode layer, for example, on one transparent substrate 1as. Light emission from the light emitting layer can be obtained from both the transparent anode layer side and the transparent cathode layer side by applying a predetermined voltage across the pair of the transparent anode layer and the transparent cathode layer.

Each of the pair of the liquid crystal shutters 2as and 2bs has a TN-type liquid crystal structure, for example, in which liquid crystals in a twisted state are sandwiched by two sheets of transparent electrodes. Further, the two sheets of transparent electrodes that sandwich the liquid crystals are held between two sheets of polarizing filters with orthogonal directions of polarization. With this configuration, light emission from the display element DE can be caused to be transmitted for display only in the A direction or the B direction by selectively applying voltage across the two sheets of transparent electrodes of each liquid crystal shutter.

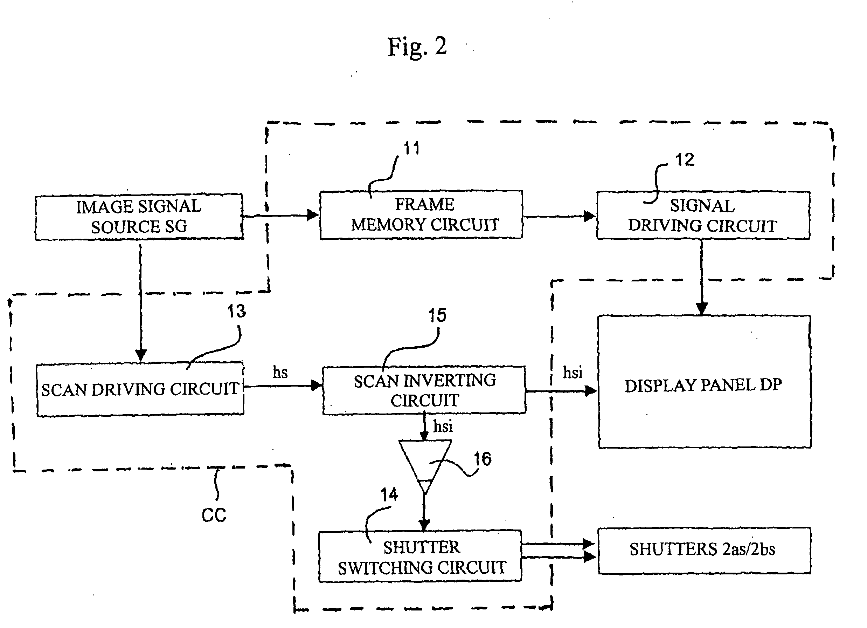

An active matrix display panel DP (see Fig. 2) can be configured in a two-dimensional plane by arranging as many of the aforementioned display elements DE as necessary for image display vertically and/or laterally in a matrix manner.

Fig. 2 shows a block diagram of an example of a display apparatus according to a first embodiment of the present invention. The apparatus comprises a display panel DP in which as many of the display elements DE shown in Fig. 1 as desired are arranged in a planar manner. It also comprises a control circuit for controlling the operation of the display panel DP. In Fig. 2, liquid crystal shutters 2as and 2bs are disposed such that each can be switched on/off in response to the display element DE. The pair of liquid crystal shutters 2as and 2bs are disposed to sandwich the display panel DP.

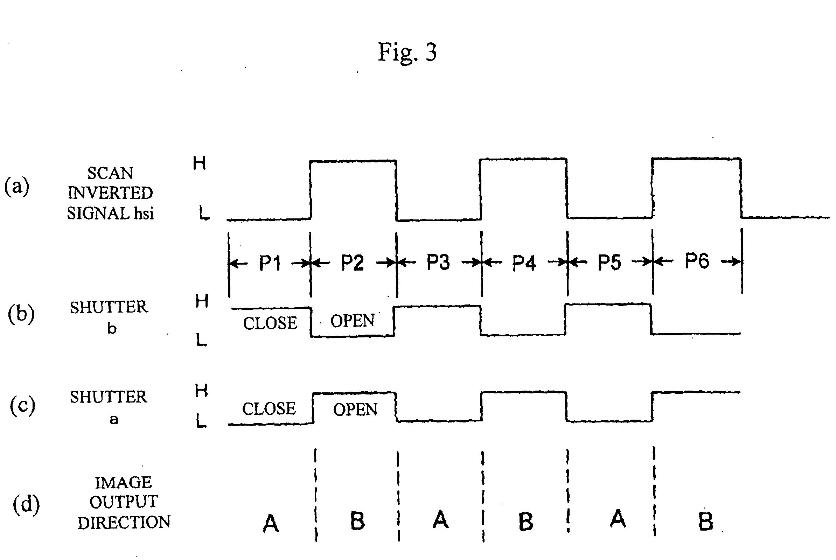

As shown in Fig. 2, the display apparatus according to the first embodiment of the present invention is provided with a control circuit CC that receives an image signal from an image signal source SG, a display panel DP that is controlled by the control circuit CC, and a plurality of pairs of liquid crystal shutters 2as and 2bs. In the following, the operation of the control circuit CC for causing image signals to be displayed on the display panel DP shown in Fig. 1 is described, focusing mainly on the relationship between the display panel DP and a plurality of pairs of liquid crystal shutters 2as and 2bs, with reference made to Figs. 2 and 3. As shown in Fig. 2, the control circuit CC is provided with a frame memory circuit 11, a signal driving circuit 12, a scan driving circuit 13, a shutter switching circuit 14, a scan inverting circuit 15, and an inverter 16. The inputs of the frame memory circuit 11 and the scan driving circuit 13 are connected to the outputs of the image signal source SG. The outputs of the shutter switching circuit 14 are connected to the liquid crystal shutters 2as and 2bs, and the output of the scan inverting circuit 15 is connected to the display panel DP.

In Fig. 2, an image signal outputted per frame from the image signal source SG is fed to the frame memory circuit 11. The image signal source SG also supplies the frame signal to the scan driving circuit 13. The scan driving circuit 13 generates a horizontal direction scan signal hs regarding the display panel DP in synchronism with the frame signal from the image signal source SG. The horizontal direction scan signal hs from the scan driving circuit 13 is fed to the scan inverting circuit 15, where the scan direction is inverted per frame, thereby generating a horizontal direction scan inverted signal hsi with which the display panel DP is driven.

Meanwhile, the image signal read from the frame memory circuit 11 is subjected to a signal processing in the signal driving circuit 12, and is then inputted into a signal line extending in the column direction on the display panel DP. In this case, as the horizontal direction scan inverted signal hsi is supplied from the scan inverting circuit 15 to a scan line extending in the row direction on the display panel DP, a video signal and the horizontal direction scan inverted signal hsi are applied to each display element DE on the display panel DP, thereby causing the display element DE disposed at a location where the activated signal and scan lines intersect to emit light. This enables a display on the display panel DP in accordance with the signal from the image signal source SG.

The horizontal scan inverted signal hsi from the scan inverting circuit 15 is further inverted in the inverter 16 back to the same signal as the original horizontal direction scan signal hs, which is then provided to the shutter switching circuit 14. In the following, an example of the operation of the shutter switching circuit 14 is described with reference to a timing chart shown in Fig. 3. In a frame period P1 in which a horizontal direction scan inverted signal hsi (Fig. 3(a)) from the scan inverting circuit 16 is low (L: non-inverted), the shutter switching circuit 14 receives a horizontal direction scan signal hs from the inverter 16, and applies a high (H) signal (Fig. 3(b)) to the liquid crystal shutter 2bs on one side and a low (L) signal (Fig. 3(c)) to the liquid crystal shutter 2as on the other side. Since both the liquid crystal shutters 2as and 2bs are composed of TN-type liquid crystal elements, for example, the liquid crystal shutter 2bs, to which the H signal is applied, closes and blocks the light path because of a reduced optical transmittance, while the liquid crystal shutter 2as, to which the low signal is applied, opens for opening the light path because of an increased optical transmittance. Namely, with reference to the image output directions shown in Fig. 1, light emitted from the display element DE passes in the A direction and is blocked in the B direction, so that the image output direction of the display apparatus is A as shown in Fig. 3(d).

In the next frame period P2, a horizontal direction scan inverted signal hsi outputted from the scan inverting circuit 15 is high, and so the horizontal direction scan on the display panel DP is initiated in a direction opposite to the scan direction in the previous frame period P1. For example, if the horizontal scan has been performed from right to left in the previous frame period P1, the scan is performed from left to right in the present frame period P2. Meanwhile, a horizontal direction scan signal hs that is provided to the shutter switching circuit 14 from the inverter 16 is low, so that a low signal is applied to the liquid crystal shutter 2bs on one side, and a high signal is applied to the liquid crystal shutter 2as on the other side. Consequently, the liquid crystal shutter 2bs of one side opens and so does the light path, while the liquid crystal shutter 2as of the other side closes and blocks the light path.

Therefore, light emitted from the display element DE is blocked in the A direction and allowed to pass in the B direction, so that an image is displayed only in the B direction on the display apparatus.

In the following frame periods P3, P4, P5, P6, ..., the same operation as described above is repeated such that the direction of image output from the display apparatus is switched alternately between the A direction and the B direction, as shown in Fig. 3(d).

When the display panel DP that displays the video signal outputted from the image signal source SG outputs an image in the image output direction A, namely, when the liquid crystal shutter 2as opens the light path, a normal image can be observed by an observer who faces the liquid crystal shutter 2as. In other words, the image can be viewed by the observer who faces the liquid crystal shutter 2as when the display image displayed on the display panel DP in the frame periods P1, P3, P5, ..., (hereafter referred to as "the first frame periods"), in which the horizontal direction scan inverted signal hsi is not inverted (namely, the horizontal direction scan inverted signal hsi is low), is outputted in the image output direction A through the open liquid crystal shutter 2as.

In the next frame periods P2, P4, P6... (hereafter referred to as "the second frame periods"), the horizontal direction scan inverted signal hsi outputted from the scan inverting circuit 15 is inverted to a low signal. The horizontal scan is therefore performed in the opposite direction on the display panel DP, and the liquid crystal shutter 2as closes and blocks the light path, while the liquid crystal shutter 2bs opens and so does the light path. Therefore, an image displayed on the display panel DP in the first frame periods is outputted in the image output direction B, and the image can be viewed by the first observer who watches the display apparatus from the side facing the liquid crystal shutter 2as. The same image as viewed by the first observer can also be viewed by the second observer who watches the display apparatus from the side facing the liquid crystal shutter 2bs in the second frame periods. Thus, information can be shared by the two persons viewing the same image displayed on the display panel DP, from either side of the display apparatus.

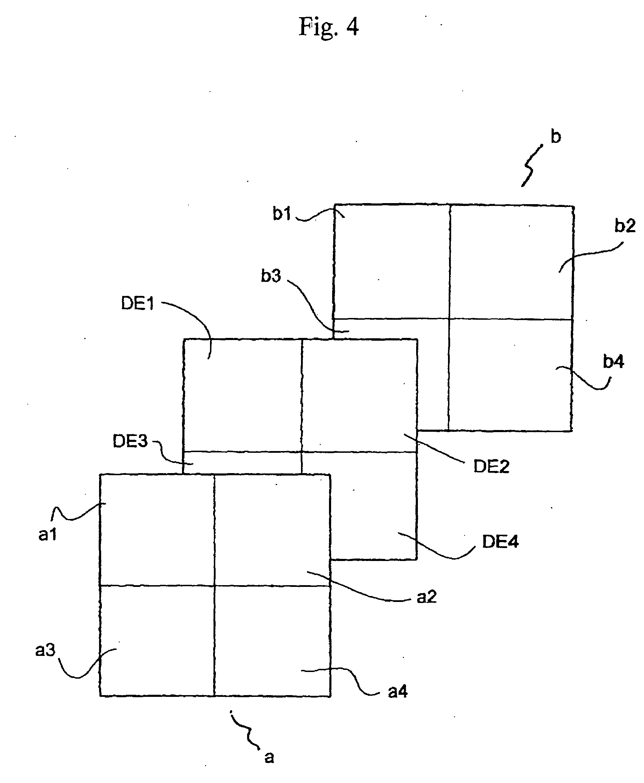

In the following, the display apparatus according to a second embodiment of the present invention is described with reference to Fig. 4. In the display apparatus according to the second embodiment, two display elements constitute one picture element, and liquid crystal shutters are disposed on the front and rear surfaces of each display element. Namely, as shown in Fig. 4, one picture element in one row consists of two display elements DE 1 and DE 2 adjoining in the row direction, and one picture element in the next row adjoining the aforementioned picture element consists of display elements DE 3 and DE 4. The display elements DE 3 and DE 4 in the next row are described as a matter of convenience for the following operational description. For each of these display elements DE 1 to DE 4, a pair of liquid crystal shutters a1, b1, a2, b2, a3, b3, a4, and b4 are disposed to sandwich each display element.

Namely, a pair of liquid crystal shutters a1 and b1 are disposed on the display element DE 1, a pair of liquid crystal shutters a2 and b2 are disposed on the display element DE 2, a pair of liquid crystal shutters a3 and b3 are disposed on the display element DE 3, and a pair of liquid crystal shutters a4 and b4 are disposed on the display element DE 4.

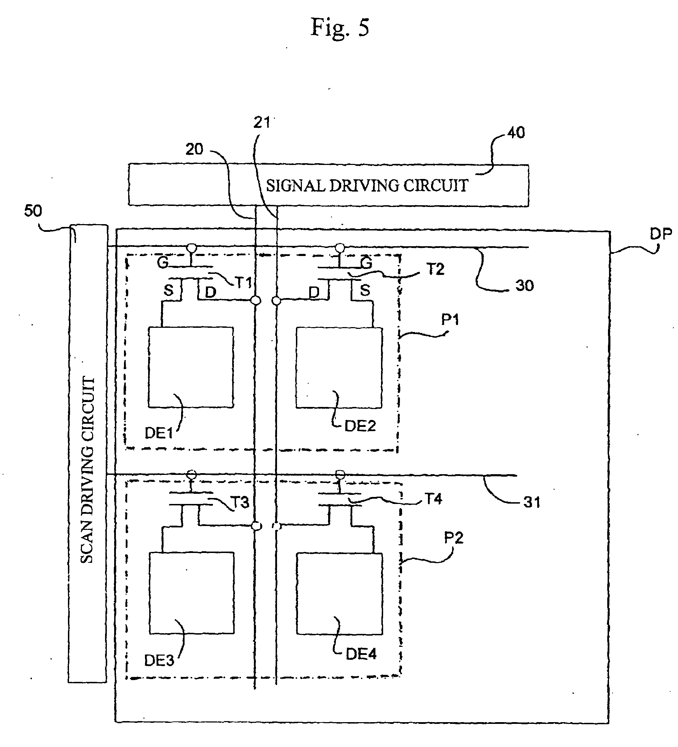

In practice, the display panel has a matrix-like structure comprising n x m picture elements, in which there are n rows, each horizontal row having 2m display elements (namely, m picture elements), each display element having the same structure as the pair of display elements DE 1 and DE 2 shown in Fig. 4, each composed of a light transmission type organic EL element. Fig. 5 shows an example of a circuit for driving each display element of the aforementioned display panel DP. However, in the display panel DP in Fig. 5, of the display elements arranged in n rows and m columns, there is only indicated a configuration of two pairs of display elements DE 1 to DE 4 that constitute two picture elements P1 and P2 that are adjoining in the column direction. In the following, the display elements DE 1 and DE 2 that constitute the picture element P1 and DE 3 and DE 4 that constitute the adjoining picture element P2 are described for ease of understanding.

As shown in Fig. 5, the pair of display elements DE 1 and DE 2 that constitute a single picture element are driven by corresponding drive transistors T1 and T2, respectively. These transistors are controlled to switch on/off by a voltage (gate voltage) applied to a scan driving wire 30 extending in the row direction. Similarly, the pair of the display elements DE 3 and DE 4 adjoining the above picture element are driven by corresponding drive transistors T3 and T4, respectively. These transistors are controlled to switch on/off by a voltage applied to a scan driving wire 31 running in the row direction.

Image data that is to be displayed on each picture element is inputted into a first signal driving wire 20 and a second signal driving wire 21 from a signal driving circuit 40. A high or low voltage is applied to the scan driving wires 30 and 31 from a scan driving circuit 50.

More specifically, the gates G of a pair of the transistors T1 and T2 adjoining in the row direction are connected to the scan driving wire 30, and the gates of a pair of the transistors T3 and T4 in the next row are connected to the scan driving wire 31. Of the four transistors T1 to T4, the drains D of the transistors T1 and T3 on one side are connected to the first signal driving wire 20, and the drains D of the transistors T3 and T4 on the other side are connected to the second signal driving wire 21. The display elements DE 1 to DE 4 comprising light transmission type organic EL elements are each connected to the source S of a corresponding transistor. When any of these transistors T1 to T4 is switched on by the voltage on the scan driving wire 30 or 31, the display element connected to the switched-on transistor emits light based on image data signals supplied from the first signal driving wire 20 and the second signal driving wire 21. In an actual matrix-like display panel DP with n rows and m columns, transistors are arranged for the individual display elements in the same manner as shown in Fig. 5, such that 2m signal driving wires and n scan driving wires are disposed.

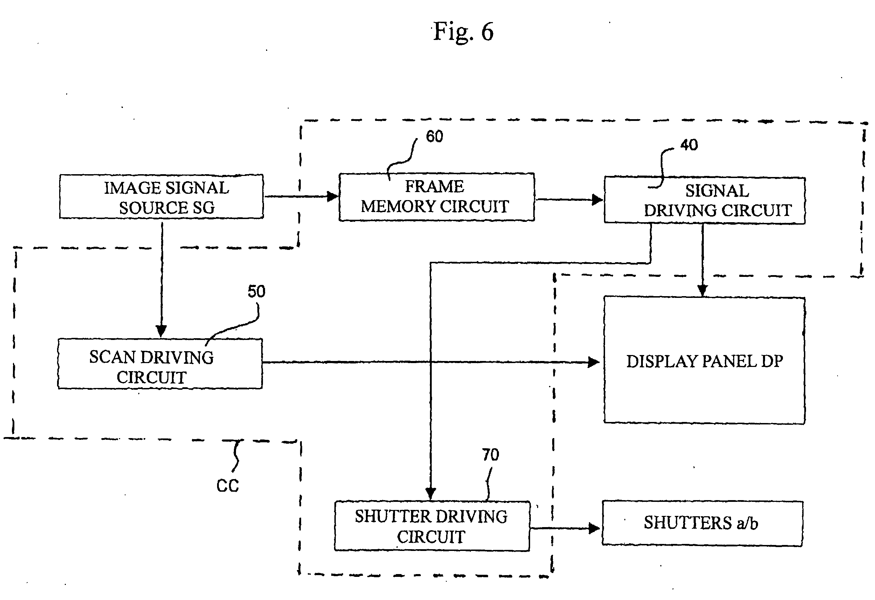

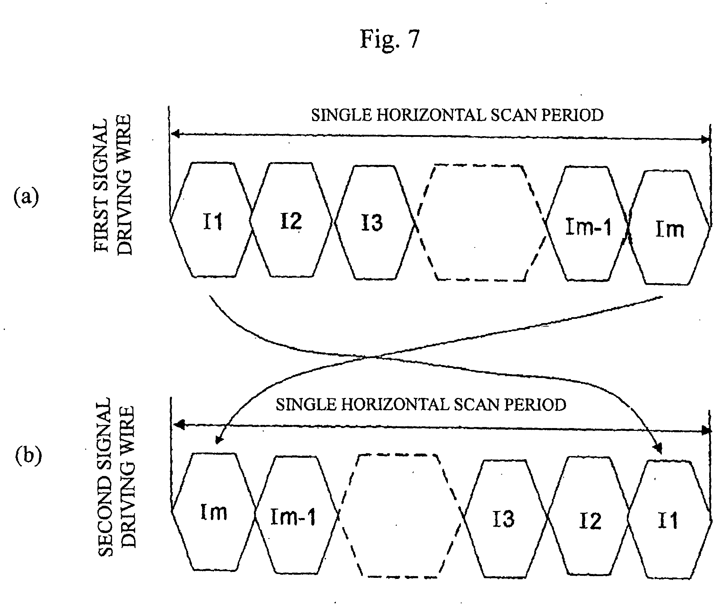

The display panel DP comprising; picture elements of n rows and m columns is operated in accordance with the timing shown in Fig. 7 under the control of a control circuit CC shown in Fig. 6. In Fig. 6, liquid crystal shutters a and b generically refer to each pair of liquid crystal shutters disposed in such a manner as to sandwich individual display element.

As shown in Fig. 6, the control circuit CC receives an image signal from an image signal source SG and drives the display panel DP and a plurality of pairs of liquid crystal shutters a and b. The control circuit CC includes a frame memory circuit 60 and a shutter driving circuit 70, in addition to the signal driving circuit 40 and the scan driving circuit 50 shown in Fig. 5. The inputs of the scan driving circuit 50 and the frame memory circuit 60 are connected to the outputs of the image signal source SG. A first output of the signal driving circuit 40 is fed to the display panel DP, and a second output is fed to the shutter driving circuit 70. The output of the shutter driving circuit 70 is connected to the liquid crystal shutters a and b.

In the same manner as already described in the first embodiment, in the apparatus shown in Fig. 6, the image signal source SG also outputs a number m pieces of image data for driving the m picture elements constituting a single horizontal row in a single horizontal scan period. The image data is fed to the frame memory circuit 60. The image signal source SG also supplies the frame signal to the scan driving circuit 50. The scan driving circuit 50 generates a horizontal direction scan signal hs for the display panel DP in synchronism with the frame signal from the image signal source SG. The horizontal direction scan signal hs from the scan driving circuit 50 drives the display panel DP.

Meanwhile, the image data read from the frame memory circuit 60 is processed in the signal driving circuit 40, and then a video signal is inputted into a signal line extending in the column direction on the display panel DP. Simultaneously, a horizontal direction scan signal hs from the scan driving circuit 50 is supplied to the display panel DP in the row direction through a scan wire. The aforementioned video signal and the horizontal direction scan signal hs are applied to each display element on the display panel DP, thereby causing a specific display element disposed at a location where the signal and scan lines intersect to emit light. This enables a display on the display panel DP in accordance with the image data.

In this case, the signal driving circuit 40 outputs the image data received from the frame memory circuit 60 into the first signal driving wire and the second signal driving wire after changing the output order in each horizontal scan period. The following describes, with reference to Fig. 7(a) and (b), the operation of the signal driving circuit 40 as it drives a pair of signal driving wires such that the same display can be viewed from the front and back surfaces of the display panel. Fig. 7(a) shows image data that the signal driving circuit 40 outputs to the first signal driving wire 20 and the second signal driving wire 21 in a single horizontal scan period. As shown in Fig. 7(a), the signal driving circuit 40 applies signals for displaying m image data items I1, I2, I3, ..., Im-1, and Im, which are to be displayed by the m picture elements in a single horizontal row, to each of the m first signal driving wires 20 in a single horizontal scan period in which one of the n scan driving wires, such as the scan driving wire 30 in Fig. 5, is driven high.

Namely, the image data I1 for the first column is provided to display elements connected to the first signal driving wire 20 of the first column, and the image data I2 for the second column is provided to display elements connected to the first signal driving wire of the second column. Subsequently, the image data Im for the m-th column is provided to display elements connected to the first signal driving wire of the m-th column in the same manner.

Simultaneously, in this horizontal scan period, the signal driving circuit 40 provides the image data Im for the m-th column to the second signal driving wire 21 of the first column, as shown in Fig. 7(b), and provides the image data Im-1 for the (m-1)th column to the second signal driving wire of the second column. Subsequently, a signal for displaying the image data I1 for the first column is provided to the second signal driving wire of the m-th column in the same manner.

Namely, in the example shown in Fig. 7(a), of the number 2m of display elements constituting the m picture elements in one horizontal row, to the m display elements connected to the first signal driving wire, there are supplied signals for displaying the image data I1 for the first column to the image data Im for the m-th column, in order from the first column to the m-th column. Meanwhile, to the m display elements connected to the second signal driving wire, there are supplied signals to display the image data Im for the m-th column to the image data I1 for the first column, in order from the first column to the m-th column. Specifically, when the pair of the display elements DE 1 and DE 2 shown in Fig. 5 constitute the picture element in the first row of the first column on the display panel DP, for example, in the case of Fig. 7, the image data I1 for the first column is supplied to the display element DE 1 and the image data Im for the m-th column is supplied to the display element DE 2.

In this case, pairs of liquid crystal shutters (a1 to a4, b1 to b4, in Fig. 4, for example) are controlled to be in an open state (i.e., transmitting state) or a closed state (i.e., light-blocking state) by the shutter driving circuit 70. In other words, in a period when one row in which a number m of picture elements each consisting of a pair of display elements (DE 1 and DE 2 in Fig. 4, for example) are arranged horizontally is scanned, the liquid crystal shutter a1 disposed on one side of the display elements (DE 1, in Fig. 5, for example) connected to the first signal driving wire (20, in Fig. 5) is controlled to be in the open state while the liquid crystal shutter b1 disposed on the other side is controlled to be in the closed state. In contrast, the liquid crystal shutter a2 disposed on one side of the display elements (DE 2, in Fig. 5, for example) connected to the second signal driving wire (21, in Fig. 5) is controlled to be in the closed state while the liquid crystal shutter b2 disposed on the other side is controlled to be in the open state.

In the same manner, in the period when the next horizontal row is scanned, the liquid crystal shutter a3 disposed on one side of the display elements (DE 3, in Fig. 5, for example) connected to the first signal driving wire (20, in Fig. 5) is also controlled to be in the open state while the liquid crystal shutter b3 disposed on the other side is controlled to be in the closed state. The liquid crystal shutter a4 disposed on one side of the display elements (DE 4, in Fig. 5, for example) connected to the second signal driving wire (21, in Fig. 5) is controlled to be in the closed state while the liquid crystal shutter b2 disposed on the other side is controlled to be in the open state.

Subsequently, for each picture element of the entire rows, the opening and closing of the liquid crystal shutters sandwiching the display elements are controlled such that, in each frame scan period, the liquid crystal shutters disposed on one side of all the display elements connected to the first signal driving wires are controlled to be in a first state (the open state, for example), and the liquid crystal shutters disposed on the other side are controlled to be in a second state (the closed state, for example), while the liquid crystal shutters disposed on one side of all the display elements connected to the second signal driving wires are controlled to be in the second state, and the liquid crystal shutters disposed on the other side are controlled to be in the first state.

Consequently, as the liquid crystal shutter disposed on one side of each display element connected to the first signal driving wire and the liquid crystal shutter disposed on the other side of each display element connected to the second signal driving wire are driven to be in a light-transmitting state simultaneously, the same screen can be viewed from either side of the display panel DP by providing a signal for displaying the image data to the first and second signal driving wires in the order already described in Fig. 7 in each horizontal scan period.

The aforementioned operation is summarized in Table 1. In Table 1, display elements DE i11 to DE im2 designate the first to the m-th picture elements, respectively, in the i-th row, where i=1 to n, and O indicates the open (transmitting) state of a liquid crystal shutter and X indicates the closed (light-blocking) state of a liquid crystal shutter.

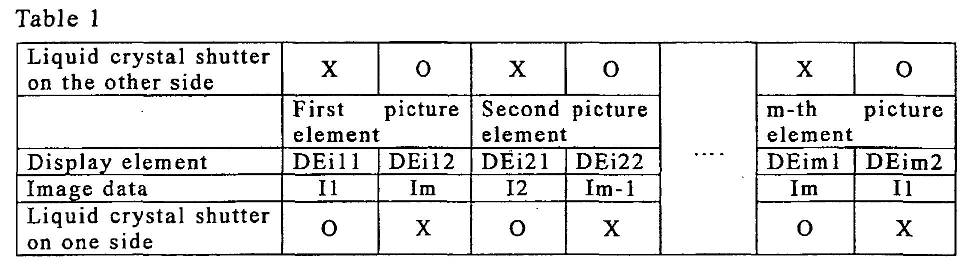

Control of the state of a pair of liquid crystal shutters is not limited to the above description. It is also possible to control the liquid crystal shutters in states different from those shown in Table 1 by changing the order of image data provided to the first and second signal driving wires in each horizontal scan period. For example, the same screen can be observed also from either side of the display panel DP by controlling the opening and closing of the liquid crystal shutters and the order of image data provided to each display element as shown in Table 2 below. In Table 2, the j-th row indicates the horizontal row following the i-th (namely, j=i+1) row.

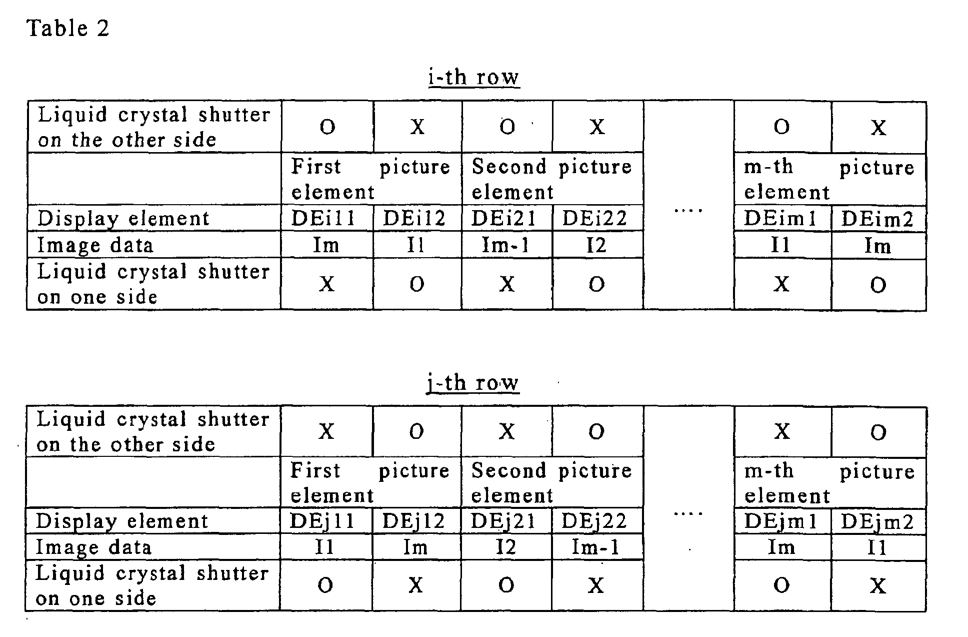

Namely, in a single horizontal scan period in which the scan driving wire of the i-th row is driven high, the signal driving circuit 40 applies signals for displaying m items of image data I1, I2, I3, ..., Im-1, and Im, which are to be displayed by m picture elements in the row, to m second signal driving wires 21, respectively. In other words, the image data I1 signal for the first column is provided to the display elements connected to the second signal driving wire 21 of the first column, and the image data I2 signal for the second column is provided to the display elements connected to the second signal driving wire of the second column. Subsequently, the image data Im signal for the m-th column is provided to the display elements connected to the second signal driving wire of the m-th column in the same manner. Simultaneously, in this horizontal scan period, the signal driving circuit 40 provides the image data Im signal for the m-th column to the first signal driving wire 20 of the first column, and provides the image data Im-1 signal for the (m-1)th column to the first signal driving wire of the second column. Subsequently, an image data I1 signal for the first column is provided to the first signal driving wire of the m-th column in the same manner.

In the next horizontal scan period, namely, a single horizontal scan period in which a scan driving wire of the j-th row is driven high, the signal driving circuit 40 applies m items of image data I1, I2, I3, ..., Im-1, and Im, which are to be displayed by the m picture elements in the row, to m first signal driving wires 20, respectively. In other words, the image data I1 signal for the first column is provided to the display elements connected to the first signal driving wire 20 of the first column, and the image data I2 signal for the second column is provided to the display elements connected to the first signal driving wire of the second column. Subsequently, the image data Im signal for the m-th column is provided to the display elements connected to the first signal driving wire of the m-th column in the same manner. Simultaneously, in this horizontal scan period, the signal driving circuit 40 provides the image data Im signal for the m-th column to the second signal driving wire 20 of the first column, and provides the image data Im-1 signal for the (m-1)th column to the second signal driving wire of the second column. Subsequently, an image data I1 signal for the first column is provided to the second signal driving wire of the m-th column in the same manner.

Thus, the same screen can be observed also from both the front and back sides of the display panel DP by controlling the opening and closing of the liquid crystal shutters as shown by O and X in Table 2, while supplying image data to the first signal driving wire and the second signal driving wire.

Although the display apparatus according to the embodiments of the present invention has been described above, the present invention is not limited to these embodiments. For example, any transparent display element can be used instead of the light transmission type organic EL element as long as the object of the present invention can be achieved.

Moreover, while the embodiments have been described on the assumption that substantially the same display is performed on the first surface side and the second surface side, control may be performed such that the first and second surfaces display differently in cases where, in a face-to-face meeting, for example, a presenter should be shown materials for smooth explanation, while the presented party is shown actual materials. In this case, with reference to Fig. 2 of the first embodiment, for example, display control can be performed based on a signal from the image signal source SG by storing first image data to be displayed on the first surface side and second image data to be displayed on the second surface side in the image signal source SG, and by providing an identification signal to the first image data and the second image data. In this case, by using a buffer memory for temporarily storing a previously inputted image, the image data through the buffer memory and image data that has been directly inputted can be controlled to be displayed simultaneously.

In this method, different displays can be shown on the first and second surface sides simultaneously in the same period. In this case, although it is not necessary to perform a process to invert scan signals, for example, it is preferable to adopt a configuration employing a memory for storing display locations on the first and second surface sides and capable of carrying out a shutter control based on the display locations stored in the memory.

While the above embodiments have been described with reference to a display panel comprising light transmission type organic EL elements, the display panel is not limited to this. Either organic or inorganic display panels may be used, and the light transmission type organic EL elements are only an example, so that obviously various types of display panel may be used. Also, the displayed objects are not limited to images and may be those of a variety of kinds, which are included in the scope of the present invention.

### INDUSTRIAL APPLICABILITY

As will be understood from the detailed description above, the invention according to claim 1 provides a display apparatus that is capable of providing the same display from either the front or the back of a display panel. Therefore, observers who face each other can share the same information with this display apparatus located between them, so that the need for a conventional multi-display apparatus is eliminated and the trouble of turning the display surface toward individual observers can be removed, for example. Furthermore, the display apparatus per se can be reduced in size and weight.

The invention according to claim 2 controls the opening and closing of liquid crystal shutters using data from a signal generator, so that the circuit configuration of control means can be simplified.

The invention according to claim 3, in contrast with the invention according to claim 1 which switches display per frame, displays a regular display and its mirror image simultaneously and enables the observation of the regular display on one side of the display apparatus and the mirror image on the other side by the opening and closing of a pair of liquid crystal shutters. Therefore, display in high resolution is possible.

The invention according to claim 4 switches a pair of display elements that display the mirror image in each horizontal scan, so that apparent resolution can be improved, thereby further improving the visibility of a display image.

The invention according to claim 5 controls the display on the display panel and the shutter means disposed on the both surfaces, so that display can be performed such that the display panel can be viewed in the same manner from a first surface side and a second surface side.

The invention according to claim 15 comprises display control means for controlling the display of the first display observed from the first surface side and of the second display observed from the second surface side, which is different from the first display. The invention also comprises shutter control means that controls the opening and closing of shutters such that a display picture element on the second surface side is screened by the second shutter means upon the first display, and a display picture element on the first surface side is screened by the first shutter means upon the second display. Therefore, different displays on the first side and the second side can be viewed almost simultaneously.

## Claims

1. A display apparatus comprising:
a display panel whose display can be observed from either side thereof;
a pair of liquid crystal shutter means disposed in such a manner as to sandwich said display panel;
display control means for displaying a mirror image of display on said display panel in every other frame or every other field; and
liquid crystal shutter control means for opening and closing said pair of liquid crystal shutter means in synchronism with the operation of said display control means in each frame scan or each field scan such that they do not open simultaneously, wherein said pair of liquid crystal shutter means are opened and closed by said liquid crystal shutter control means such that said mirror image can be observed as the original display on one side of said display panel.

2. The display apparatus according to claim 1, wherein
said display control means comprises a scan inverting circuit for inverting the direction of a horizontal scan on said display panel in each frame or each field; and
said liquid crystal shutter control means controls the switching of the opening and closing of said pair of liquid crystal shutter means in response to an output from said scan inverting circuit.

3. A display apparatus comprising:
a display panel comprising a plurality of picture elements of which each is composed of a pair of display elements, wherein display can be observed from either side of said display panel;
a pair of liquid crystal shutter means disposed in such a manner as to sandwich said display panel;
display control means for driving each of said display elements such that a mirror image of display that is being made by a set of display elements consisting of one of said pair of display elements can be displayed by another set of display elements consisting of the other of said pair of display elements; and
liquid crystal shutter control means for opening and closing said pair of liquid crystal shutter means in synchronism with the operation of said display control means in each frame scan or each field scan such that they do not open simultaneously, wherein said pair of liquid crystal shutter means are opened and closed by said liquid crystal shutter control means such that said mirror image can be observed as the original display on one side of said display panel.

4. The display apparatus of claim 3, wherein said display control means causes said mirror image to be displayed alternately in each horizontal scan by the one set and the other set of said pair of display elements.

5. A display apparatus comprising:
a display panel having a plurality of picture elements that perform display based on an input signal, said display panel being capable of display on both surfaces, namely a first surface and a second surface, thereof, using a picture element at a selected location;
first shutter means and second shutter means disposed on said first surface side and said second surface side, respectively, said first and second shutter means being capable of opening and closing for a single picture element or a plurality of picture elements; and
control means comprising display control means for performing display control such that a first display observed from said first surface side and a second display observed from said second surface side can be viewed as the same display, and shutter control means for controlling the opening and closing of shutters such that the display picture elements on said second surface side are screened by said second shutter means upon said first display, and the display picture elements on said first surface side are screened by said first shutter means upon said second display.

6. The display apparatus according to claim 5, wherein said display control means, while switching the display period of said first display and said second display, performs display control such that said first display and said second display have a relationship where they are substantially mirror images of each other upon viewing said first display or said second display from either said first surface side or said second surface side with said shutters open.

7. The display apparatus according to claim 6, wherein said display period in which said first display and said second display are switched is a unit scan period based on a single field unit or a single frame unit.

8. The display apparatus according to claim 6, wherein said shutter control means controls the opening and closing of shutters in synchronism with the switching of said display period by said display control means.

9. The display apparatus according to claim 5, wherein said control means comprises:
a memory circuit for storing a data signal in each scan unit of said picture element based on said input signal;
a scan inverting circuit for inverting the scan order in each said scan unit;
a signal driving circuit for outputting a data signal to said display panel in order to perform the first display by said scan order and the second display by the inverted scan order based on said inverted scan signal at different times, based on said data signal stored in said memory circuit and said inverted scan signal outputted from said scan inverting circuit;
a signal inverting circuit for inverting the inverted scan signal outputted from said scan inverting circuit; and
a shutter switching circuit for controlling the opening and closing of said first shutter means and said second shutter means based on an output signal from said signal inverting circuit, wherein, upon alternatively displaying either said first display or said second display outputted from said signal driving circuit in each said scan unit, the display surface side on which display has not been selected is screened alternatively by said first or second shutter means.

10. The display apparatus according to any of claims 5 to 9, wherein said first and second shutter means are formed by liquid crystal panels disposed on said first display surface and said second display surface, respectively, in an opposing manner.

11. A display apparatus comprising:
a display panel having a plurality of picture elements, each including at least two, namely a first and a second, display elements disposed closely to each other, which is capable of display from both surfaces, namely a first display surface and a second display surface, thereof, using a picture element at a selected location;
first shutter means and second shutter means disposed on said first display surface side and said second display surface side, respectively, that are capable of opening and closing for each of said display elements; and
control means comprising display control means for performing display control such that a first display observed from said first display surface side and a second display observed from said second display surface side can be viewed as the same display, and shutter control means for controlling the opening and closing of shutters such that the display picture elements on said second display surface side are screened by said second shutter means upon said first display, and the display picture elements on said first display surface side are screened by said first shutter means upon said second display.

12. The display apparatus according to claim 11, wherein said display control means, while switching the display period of said first display and said second display, and performs display control such that said first display and said second display have a relationship where they are substantially mirror images of each other upon viewing said first display and said second display from either said first surface side or said second surface side with said shutters open.

13. The display apparatus according to claim 7 or 8, wherein said control means comprises:
a memory circuit for storing a data signal in each scan unit of said picture element based on said input signal;
a scan driving circuit for providing a scan driving signal to said display panel in the scan order of each said scan unit;
a signal driving circuit for changing the output order of said image signal received from said memory circuit in each scan order, while outputting to said display panel an image signal that is used to perform a first image display by said scan order and a second image display by the inverted scan order based on an inverted scan signal at different times, based on said data signal stored in said memory circuit and the scan driving signal outputted from said scan driving circuit;
a signal inverting circuit for inverting the inverted scan signal outputted from said scan inverting circuit; and
a shutter switching circuit for controlling the opening and closing of said first shutter means and said second shutter means based on an output signal from said signal inverting circuit, wherein, upon alternatively displaying either said first display or said second display based on said image signal outputted from said signal driving circuit in each said scan unit, the display surface side on which display has not been selected is screened alternatively by said first or second shutter means.

14. The display apparatus according to any one of claims 11 to 13, wherein said first and second shutter means are formed by liquid crystal panels disposed on said first display surface and said second display surface, respectively, in an opposing manner.

15. A display apparatus comprising:
a display panel having a plurality of picture elements that perform display based on an input signal, said display panel being capable of display on both surfaces, namely a first surface and a second surface, thereof, using a picture element at a selected location;
first shutter means and second shutter means disposed on said first surface side and said second surface side, respectively, that are capable of opening and closing for a single picture element or a plurality of picture elements; and
control means comprising display control means for performing display control of a first display observed from said first surface side and a second display, which is different from said first display, observed from said second surface side, and shutter control means for controlling the opening and closing of shutters such that the display picture elements on said second surface side are screened by said second shutter means upon said first display, and the display picture elements on said first surface side are screened by said first shutter means upon said second display.

16. A display apparatus comprising:
a display panel having a plurality of picture elements, each including at least two, namely a first and a second, display elements disposed closely to each other, that can provide a display on both surfaces, namely a first display surface and a second display surface, thereof, using a picture element at a selected location;
first shutter means and second shutter means disposed on said first surface side and said second surface side, respectively, that are capable of opening and closing for each said display element; and
control means comprising display control means for performing display control of a first display observed from said first display surface side and a second display, which is different from said first display, observed from said second display surface side, and shutter control means for controlling the opening and closing of shutters such that the display picture elements on said second display surface side are screened by said second shutter means upon said first display, and the display picture elements on said first display surface side are screened by said first shutter means upon said second display.

17. The display apparatus according to any of claims 5 to 16, wherein said display panel and said shutter means are controlled by the same circuit.

18. A terminal apparatus comprising the display apparatus according to any one of claims 5 to 17.
